# EUROPEAN PATENT APPLICATION

(11) **EP 2 629 075 A1**
(43) Date of publication of application: **21.08.2013**
(21) Application number: 12001105.1
(22) Date of filing: 20.02.2012
(51) Int. Cl.: G01L 19/04, G01D 3/036

(54) **Method for determining a sensor value**

(71) Applicant: Sony Ericsson Mobile Communications AB, 221 88 Lund (SE)
(72) Inventor: Johansson, Allan, 224 56 Lund (SE); Knutsson, Lars, 275 95 Sjöbo (SE); Åberg, Peter, 28831 Vinslöv (SE); Rosqvist, Björn, 226 54 Lund (SE)
(74) Representative: Banzer, Hans-Jörg

(57) **Abstract**

The present invention relates to a method for determining a sensor value of a sensor (13). According to the method, a first electrical supply voltage (VS1) is supplied to the sensor (13) and a first electrical resistance of the sensor (13) is detected. Then, a second electrical supply voltage (VS2) is supplied to the sensor and a second electrical resistance of the sensor (13) is detected. The second electrical supply voltage (VS2) is different from the first electrical supply voltage (VS1). The sensor value is automatically determined depending on the first electrical supply voltage (VS1), the second electrical supply voltage (VS2), the first electrical resistance, and the second electrical resistance.

## Description

### FIELD OF THE INVENTION

The present invention relates to a method for determining a sensor value of a sensor, especially to a method for determining a temperature compensated strain gauge value of a strain gauge sensor. The present application relates furthermore to a system utilizing the aforementioned method, a touch sensitive user interface comprising the system, and a mobile device comprising the touch sensitive user interface.

### BACKGROUND OF THE INVENTION

Touch panels are known in the art for controlling devices via a user interface. The touch panel may be arranged on top of a display forming a so-called touch screen. A touch screen provides a very intuitive way of operating the device. Information may be displayed on the display and in response to the information displayed on the display, the user may touch the display for initiating actions or operations. The touch panel may work by detecting a change of capacity when the user approaches or touches the surface of the touch panel. Such a so-called capacitive touch panel may also provide a location information where the user touches the touch panel. This may be used to provide a two-dimensional input means as the user interface. However, especially in connection with complex applications, a three-dimensional input means may be desirable. A third input dimension may be accomplished by measuring a force being applied by the user to the surface of the touch screen. Using a strain gauge sensor may be very effective in measuring a strain on for example a glass window created by a force applied by the user. However, strain gauge sensors are very sensitive for environmental effects such as temperature changes.

Therefore, there is a need to provide a simple, reliable and robust measuring of a strain, especially with respect to temperature variations.

### SUMMARY OF THE INVENTION

According to the present invention, this object is achieved by a method for determining a sensor value of a sensor as defined in claim 1, a system as defined in claim 7, a touch sensitive user interface as defined in claim 10, and a mobile device as defined in claim 11. The dependent claims define preferred and advantageous embodiments of the invention.

According to an aspect of the present invention, a method for determining a sensor value of a sensor is provided. According to the method, a first electrical supply voltage is supplied to the sensor. A first electrical resistance of the sensor is detected while the first electrical supply voltage is supplied to the sensor. Then, a second electrical supply voltage is supplied to the sensor. The second electrical supply voltage is different from the first electrical supply voltage. A second electrical resistance of the sensor is detected while the second electrical supply voltage is supplied to the sensor. The sensor value is automatically determined depending on the first electrical supply voltage, the second electrical supply voltage, the first electrical resistance, and the second electrical resistance. The inventors found out that some sensor materials, especially semiconductor materials of for example a strain gauge sensor, for example indium tin oxide or an n-type semiconductor-based strain gauge sensor, exhibit different effects by temperature variations when varying a supply voltage to the sensor. Thus, knowing for example characteristic diagrams of the sensor material at different supply voltages and temperatures, a temperature dependency may be compensated by operating the sensor subsequently at two different electrical supply voltages. For example, a strain gauge sensor may be operated at two different supply voltages supplied to the ends of the strain gauge sensor while a constant strain is exerted on the strain gauge sensor. Corresponding resistance values of the strain gauge sensor may be determined while the different electrical supply voltages are supplied to the sensor, for example by measuring a current through the strain gauge sensor. Based on these two measurements the unknown dimension temperature may be eliminated and thus a temperature compensated strain gauge value may be determined or the effects created by temperature variations on the strain gauge value may be greatly decreased.

According to an embodiment, a first characteristic dependency is provided which indicates a resistance of the strain gauge sensor versus temperature and strain at the first electrical supply voltage. Furthermore, a second characteristic dependency is provided which indicates a resistance of the strain gauge sensor versus temperature and strain at the second electrical supply voltage. A temperature compensated strain gauge value is determined as the sensor value depending on the first characteristic dependency, the second characteristic dependency, the first electrical resistance and the second electrical resistance. The first and second characteristic dependencies may comprise for example characteristic diagrams or look-up tables. Furthermore, the characteristic dependencies may comprise mathematical formulas describing or approximating the characteristic dependencies. Thus, determining the temperature compensated sensor value, especially a temperature compensated strain gauge value, may be easily performed by a microcontroller or processor and can therefore be realized cost efficient in for example a mobile device.

According to an embodiment, the sensor comprises indium tin oxide. The indium tin oxide may be coated on a glass surface in a thin layer for example in the form of a meander for realizing a strain gauge sensor configured to detect a strain on the glass window created by a force applied by a user on the glass window. As a thin layer of indium tin oxide has a high transparency, the constituted strain gauge sensor may be a arranged on a top of a display for constituting a touch screen of a user interface.

According to another aspect of the present invention, a system is provided. The system comprises a sensor and a processing unit coupled to the sensor. The processing unit is configured to supply a first electrical supply voltage to the sensor, and to detect a first electrical resistance of the sensor when the first electrical supply voltage is supplied to the sensor. Then, the processing unit supplies a second electrical supply voltage to the sensor which is different from the first electrical supply voltage, and detects a second electrical resistance of the sensor when the second electrical supply voltage is supplied to the sensor. Depending on the first electrical supply voltage, the second electrical supply voltage, the first electrical resistance, and the second electrical resistance the processing unit determines a sensor value. Thus, for example, a temperature compensated strain gauge value of a strain gauge sensor may be determined based on the fact that the strain gauge sensor exhibits a different temperature dependency at different supply voltages.

According to an embodiment, the processing unit comprises a Wheatstone bridge. The sensor is arranged in a leg or branch of the Wheatstone bridge. The processing unit is configured to supply a first reference voltage to the Wheatstone bridge and thus the first electrical supply voltage is supplied to the sensor. While the first reference voltage is supplied to the Wheatstone bridge, the first electrical resistance of the sensor is determined by using the Wheatstone bridge. Then, a second reference voltage is supplied to the Wheatstone bridge and upon the second reference voltage supplied to the Wheatstone bridge the second electrical supply voltage is supplied to the sensor. While the second reference voltage is supplied to the Wheatstone bridge, the second electrical resistance of the sensor is detected utilizing the Wheatstone bridge. As the Wheatstone bridge is adapted to determine a resistance and changes in a resistance very accurately, especially if the changes are very small, the first and the second electrical resistances may be determined very accurately and thus the sensor value may be determined with high accuracy.

Furthermore, the system may be configured to perform the above-described method and embodiments.

According to another aspect of the present invention, a touch sensitive user interface is provided which comprises the above-described system and a carrier plate. The sensor comprises a strain gauge sensor arranged on the carrier plate. The carrier plate may comprise for example a glass window or a resin layer. The carrier plate may be touched or pressed by a user as a user input. Due to a touch or pressing of the carrier plate, a strain is exerted on the strain gauge sensor arranged on the carrier plate and thus a touching or pressing force applied by the user to the carrier plate may be determined by the system.

According to another aspect of the present invention, a mobile device is provided. The mobile device comprises the touch sensitive user interface as described above. The mobile device may comprise furthermore a display for outputting information to the user. The carrier plate may comprise a transparent material, for example glass or resin, and may be arranged on top of the display. Thus, a touch sensitive display, a so-called touch screen, can be realized. Due to the strain gauge sensor arranged on the transparent carrier plate a force applied by the user to the carrier plate may be determined. The sensor value representing the pressure or force exerted by the user may be used in the mobile device as a control value of the user interface.

According to an embodiment, the mobile device comprises a mobile phone, a personal digital assistant, a mobile music player, a mobile computer or a mobile navigation system. However, the mobile device may comprise any other kind of portable or handheld devices.

According to an embodiment, the first electrical supply voltage and the second electrical supply voltage may each be in a range of 0.1 to 3.0 V. Therefore, the first and second electrical supply voltages may be generated based on a power supply voltage of a mobile device. However, the voltage range may exceed 3 V, e.g. for increasing accuracy of determining the sensor value.

Although specific features described in the above summary and in the following detailed description are described in connection with specific embodiments and aspects, it is to be understood that the features of the embodiments and aspects may be combined with each other unless specifically noted otherwise.

### BRIEF DESCRIPTION OF THE DRAWINGS

The invention will now be described in more detail with reference to the accompanying drawings.
Fig. 1 shows schematically a mobile device according to an embodiment of the present invention.
Fig. 2 shows a processing unit comprising a Wheatstone bridge according to an embodiment of the present invention.
Fig. 3 shows a processing unit comprising a Wheatstone bridge according to another embodiment of the present invention.
Fig. 4 shows method steps of a method according to an embodiment of the present invention.

### DETAILED DESCRIPTION OF PREFERRED EMBODIMENTS

In the following, exemplary embodiments of the invention will be described in more detail. It has to be understood that the following description is given only for the purpose of illustrating the principles of the invention and is not to be taken in a limiting sense. Rather, the scope of the invention is defined only by the appended claims and is not intended to be limited by the exemplary embodiments hereinafter.

It is to be understood that the features of the various exemplary embodiments described herein may be combined with each other unless specifically noted otherwise. Same reference signs in the various drawings and the following description refer to similar or identical components.

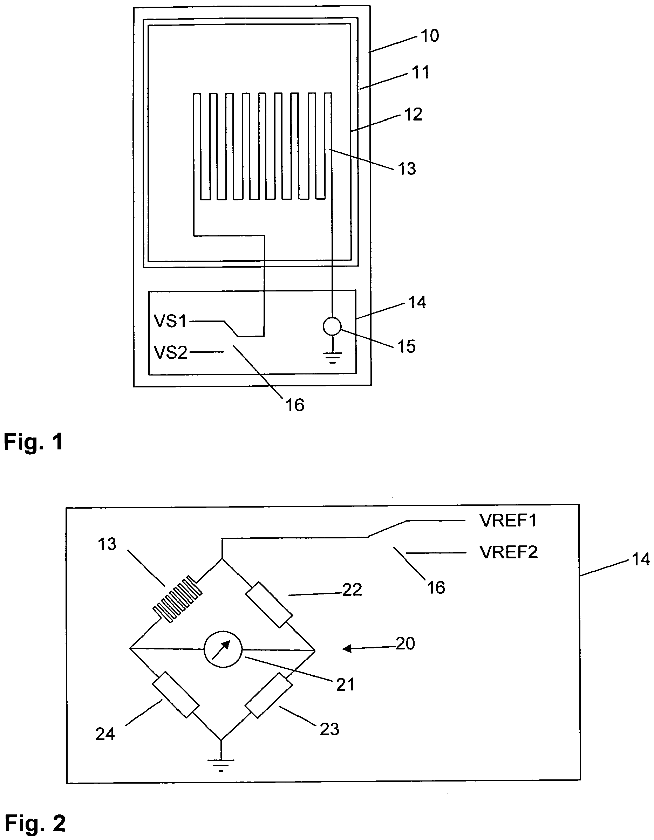

Fig. 1 shows a mobile device 10, for example a mobile phone. The mobile device 10 comprises among other parts (not shown) a display 11 and a touch panel 12 which is arranged on top of the display 11. The touch panel 12 may comprise a glass window and an array or grid of electrodes (not shown) for detecting an approach of a finger of a user to a certain position on the touch panel 12 by a change of capacitance of the electrodes as it is known in the art. Furthermore, the touch panel 12 comprises a strain gauge sensor 13 arranged on a surface of the touch panel 12. The strain gauge sensor 13 may comprise a layer of indium tin oxide or a semiconductor material, for example a heavily doped n-type semiconductor material. The strain gauge sensor 13 may be coated or laminated on the surface of the touch panel 12. The strain gauge sensor may comprise an electric meander line as shown in Fig. 1 or an electric line of any other shape appropriate to detect a strain on the touch panel 12 created by a force applied by a user touching the touch panel 12. The ends of the electric line of the strain gauge sensor 13 are coupled to a processing unit 14. The processing unit 14 couples one end of the strain gauge sensor via a current measuring unit 15 to ground and the other end of the strain gauge sensor 13 to a switch 16. The switch 16 couples the strain gauge sensor selectively to a first electrical supply voltage VS1 or a second electrical supply voltage VS2 under control of for example a microcontroller or a microprocessor.

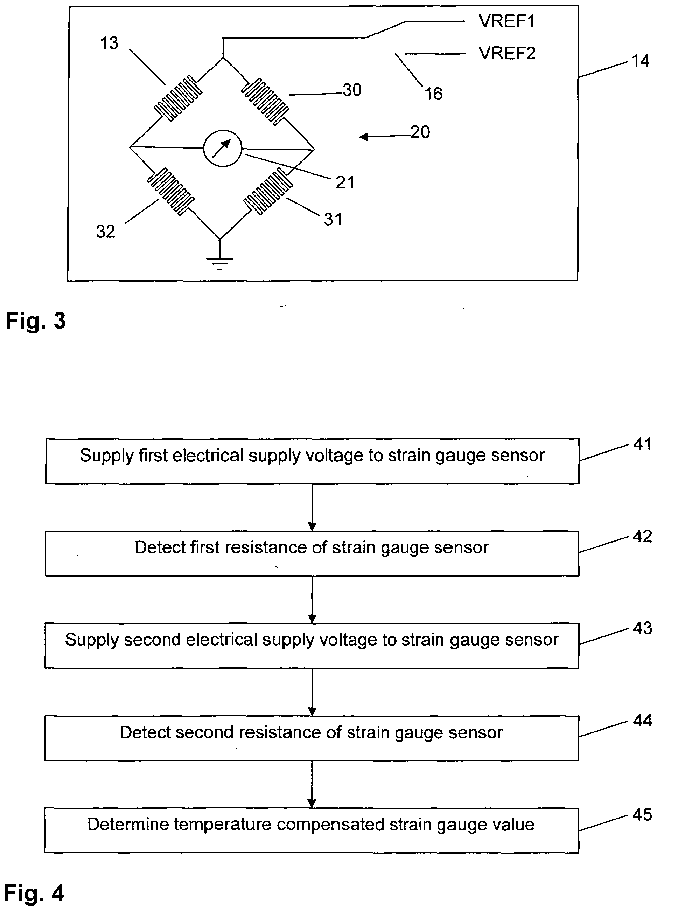

Operation of the processing unit 14 will be now described in connection with Figs. 1 and 4. For determining a strain created by a force applied to the touch panel 12, in step 41 the first electrical supply voltage VS1 is supplied via the switch 16 to the strain gauge sensor 13. Based on the first electrical supply voltage and an electrical current measured by the current measuring unit 15 a first resistance of a strain gauge sensor is determined (step 42). Then, the second electrical supply voltage VS2 is supplied via the switch 16 to the strain gauge sensor 13 in step 43. Based on the second electrical supply voltage VS2 and a current measured by the current measuring unit 15 a second resistance of the strain gauge sensor 13 is determined in step 44. By changing the supply voltage the material of the strain gauge sensor 13 follows different characteristic dependencies on resistance versus temperature and strain. By switching between the two different supply voltages and measuring the resistance while the strain is still the same (given that the time between the switching is short), the temperature effect can be calculated and compensated, and a temperature compensated strain gauge value can be determined in step 45.

In Fig. 1 the resistance of the strain gauge sensor 13 is determined by measuring the current through the strain gauge sensor 13 with the current measuring unit 15. However, this is just an example. Fig. 2 shows another embodiment for determining the resistance of the strain gauge sensor 13 by using a Wheatstone bridge 20. In one leg of the Wheatstone bridge the strain gauge sensor 13 is coupled. The other legs of the Wheatstone bridge comprise resistors 22-24. The Wheatstone bridge 20 can be selectively supplied with either a first reference voltage VREF1 or a second reference voltage VREF2 via switch 16. By switching between the first reference voltage VREF1 and the second reference voltage VREF2 a voltage supplied to the strain gauge sensor 13 is also changed. The resistance of the strain gauge sensor 13 may be determined by the Wheatstone bridge 20 as it is known by the art, for example by balancing the resistors 22-24 such that a voltage measured at voltage measuring unit 21 becomes zero or by determining the resistance of the strain gauge sensor 13 based on the voltage indicated by the voltage measuring unit 21. As described above, the material of the strain gauge sensor 13, for example a heavy doped n-type semiconductor or an indium tin oxide (ITO) material, follows different curves on resistance versus temperature and strain when being supplied with different supply voltages. Thus, there are two unknown parameters, the strain and the temperature. Due to the two measurements at different electrical supply voltages, these two unknown parameters can be determined or at least the strain can be determined without knowing the temperature.

Fig. 3 shows a further embodiment of the processing unit 14. The processing unit 14 comprises a Wheatstone 20 which is supplied via a switch 16 with either a first reference voltage VREF1 or a second reference voltage VREF2. The Wheatstone bridge 20 has in each leg a strain gauge sensor 13, 30-32. The strain gauge sensors 13, 30-32 may be arranged in separate areas on the touch panel 12. For example, the strain gauge sensors 13 and 31 may be arranged such on the touch panel that they are adapted to determine a strain in a first direction and the strain gauge sensors 30 and 32 may be arranged such on the touch panel 12 that they are adapted to determine a strain in a second direction of the touch panel which is perpendicular to the first direction. As described above, the Wheatstone bridge 20 is supplied subsequently with the first reference voltage VREF1 and the second reference voltage VREF2, and for each reference voltage the resistances of the strain gauge sensors 13, 30-32 are determined. Based on the characteristic dependencies of the strain gauge sensors indicating the resistance of the strain gauge sensor versus temperature and strain at the first and second supply voltages, a temperature compensated strain gauge value for each direction, the first direction and the second direction, can be determined.

While exemplary embodiments have been described above, various modifications may be implemented in other embodiments. For example, the pattern of the strain gauge sensor 13 may have any other shape than the meander shape shown in Fig. 1, for example a zigzag shape. Furthermore, the characteristic dependencies indicating the resistance of the strain gauge sensor 13 versus temperature and strain at the first electrical supply voltage and the second electrical supply voltage may be implemented as a characteristic diagram, a look-up table or a mathematical formula. Furthermore, it is to be understood that the reference voltages VREF1 and VREF2 as well as the supply voltages VS1 and VS2 may be selected as appropriate, for example in the range of 0-3 V, for example 1 V for the first supply voltage VS1 and 2 V for the second supply voltage VS2. Moreover, the exemplary embodiments of Fig. 2 and 3 show a quarter Wheatstone bridge and a full Wheatstone bridge. However, any other bridge configuration may be use instead.

Finally, it is to be understood that all the embodiments described above are considered to be comprised by the present invention as it is defined by the appended claims.

## Claims

1. A method for determining a sensor value of a sensor, the method comprising:
- supplying a first electrical supply voltage (VS1) to the sensor (13),
- detecting a first electrical resistance of the sensor (13) when being supplied with the first electrical supply voltage (VS1),
- supplying a second electrical supply voltage (VS2) to the sensor (13), the second electrical supply voltage (VS2) being different from the first electrical supply voltage (VS1),
- detecting a second electrical resistance of the sensor (13) when being supplied with the second electrical supply voltage (VS2), and
- automatically determining the sensor value depending on the first electrical supply voltage (VS1), the second electrical supply voltage (VS2), the first electrical resistance, and the second electrical resistance.

2. The method according to claim 1, wherein the sensor (13) comprises a strain gauge sensor.

3. The method according to claim 2, comprising:
- providing a first characteristic dependency, the first characteristic dependency indicating a resistance of the strain gauge sensor (13) versus temperature and strain at the first electrical supply voltage (VS1), and
- providing a second characteristic dependency, the second characteristic dependency indicating a resistance of the strain gauge sensor (13) versus temperature and strain at the second electrical supply voltage (VS2),
wherein determining the sensor value comprises determining a temperature compensated strain gauge value depending on the first characteristic dependency, the second characteristic dependency, the first electrical resistance and the second electrical resistance.

4. The method according to any one of the preceding claims, wherein the sensor (13) comprises a semiconductor material.

5. The method according to any one of the preceding claims, wherein the sensor (13) comprises indium tin oxide.

6. The method according to any one of the preceding claims, wherein the sensor (13) comprises an n-type semiconductor material.

7. A system, comprising:
- a sensor (13), and
- a processing unit (14) coupled to the sensor, the processing unit (14) being configured to supply a first electrical supply voltage (VS1) to the sensor (13), to detect a first electrical resistance of the sensor (13) when the first electrical supply voltage (VS1) is supplied to the sensor (13), to supply a second electrical supply voltage (VS2) different from the first electrical supply voltage (VS1) to the sensor (13), to detect a second electrical resistance of the sensor (13) when the second electrical supply voltage (VS2) is supplied to the sensor (13), and to determine a sensor value depending on the first electrical supply voltage (VS1), the second electrical supply voltage (VS2), the first electrical resistance, and the second electrical resistance.

8. The system according to claim 7, wherein the processing unit (14) comprises a Wheatstone bridge (20), wherein the sensor (13) is arranged in a leg of the Wheatstone bridge (20), wherein the processing unit (14) is configured to supply a first reference voltage (VREF1) to the Wheatstone bridge (20) to supply the first electrical supply voltage (VS1) to the sensor (13), and to supply a second reference voltage (VREF2) to the Wheatstone bridge (20) to supply the second electrical supply voltage (VS2) to the sensor (13).

9. The system according to claim 7 or 8, wherein the system is configured to perform the method according to any one of claims 1-6.

10. A touch sensitive user interface, comprising:
- the system according to any one of claims 7-9, and
- a carrier plate (12) for being touched or pressed by a user as a user input, wherein the sensor (13) comprises a strain gauge sensor arranged on the carrier plate (12).

11. A mobile device, comprising the touch sensitive user interface according to claim 10.

12. The mobile device according to claim 11, further comprising a display (11) for outputting information to the user, wherein the carrier plate (12) comprises a transparent material and is arranged on top of the display (11).

13. The mobile device according to claim 11 or 12, wherein the mobile device (10) comprises at least one mobile device of a group consisting of a mobile phone, a personal digital assistant, a mobile music player, a mobile computer, and a mobile navigation system.
